(19) **Europäisches Patentamt**

**European Patent Office**

**Office européen des brevets**

(11) Veröffentlichungsnummer : **0 183 045**
**B1**

(12) # EUROPÄISCHE PATENTSCHRIFT

(45) Veröffentlichungstag der Patentschrift :
**25.05.88**

(51) Int. Cl.⁴ : **H 05 K 7/02**

(21) Anmeldenummer : **85113368.6**

(22) Anmeldetag : **22.10.85**

(54) Stromversorgungsgerät.

(30) Priorität : **08.11.84 DE 3440756**

(43) Veröffentlichungstag der Anmeldung :
**04.06.86 Patentblatt 86/23**

(45) Bekanntmachung des Hinweises auf die Patenterteilung : **25.05.88 Patentblatt 88/21**

(84) Benannte Vertragsstaaten :
**DE FR GB SE**

(56) Entgegenhaltungen :
**CH-A- 256 367**
**DE-A- 3 125 809**
**DE-B- 2 110 462**
**FR-A- 2 371 857**
**US-A- 2 967 267**
**US-A- 4 002 398**

(73) Patentinhaber : **CEAG Licht- und Stromversorgungstechnik GmbH**
**Kallstadter Strasse 1**
**D-6800 Mannheim 31 (DE)**

(72) Erfinder : **Mayer, Hartwig**
**Untere Wingert 14**
**D-6934 Neckargerach (DE)**

(74) Vertreter : **Kempe, Wolfgang, Dr. et al**
**c/o BROWN, BOVERI & CIE AG ZPT Postfach 351**
**D-6800 Mannheim 31 (DE)**

EP 0 183 045 B1

Jouve, 18, rue St-Denis, 75001 Paris, France

**Beschreibung**

Die Erfindung betrifft ein Stromversorgungsgerät gemäß dem Oberbegriff des Anspruches 1.

Derartige Stromversorgungsgeräte dienen zur elektrischen Versorgung bspw. eines Großcomputers mit einem hohen Strom bei niedriger Spannung. Dabei ist der innere schaltungsmäßige Aufbau eines derartigen Netzgerätes wie folgt :

Ein von dem Netz herkommender, den Netzschwankungen unterworfener Wechselstrom wird in dem Versorgungsgerät gefiltert und gleichgerichtet. Mittels einer von einer Regelstufe beeinflußten Schaltstufe wird der gefilterte und gleichgerichtete Strom z. B. durch Pulsbreitenmodulation in einen hochfrequenten Wellenstrom umgeformt, der der Primärwicklung eines Leistungstransformators zugeführt wird. Dessen Sekundärsignal wird wieder gleichgerichtet, um einen unipolaren Pulsstrom zu erzeugen, dessen Arbeitstakt eine Funktion der An- und Ausschaltzeiten der Transistorschaltung ist. Der gepulste Strom wird gefiltert und geglättet bspw. von einem konventionellen LC-Filter, wodurch die gewünschte Ausgangsgleichspannung und der Ausgangsgleichstrom erzeugt wird.

Diese Schaltungsanordnungen sind an sich bekannt und Gegenstand der vorliegenden Erfindung ist nicht die Schaltungsanordnung, sondern die räumliche Unterbringung der einzelnen Baugruppen innerhalb eines Gehäuses.

Die einzelnen Bauelemente, insbesondere der Transformator, die Drossel und die in der Schaltungsanordnung verwendeten Kondensatoren, sind in ihren Abmessungen groß und daher wird der Bauart, d. h. dem Zusammenbau besondere Aufmerksamkeit zu widmen sein. Zunächst ist zu versuchen, eine besonders hohe Packungsdichte zu erzielen. Dies hat aber zur Folge, daß sich die einzelnen Bauelemente gegenseitig beeinflussen können.

Ein Versorgungsgerät in dem die einzelnen Bauelemente so untergebracht sind, daß eine gegenseitige Störbeeinflussung weitgehend vermieden wird, ist schon seit geraumer Zeit bekannt. Dabei sind aufgrund der Zuordnung der einzelnen Baugruppen zueinander viele Verbindungsleitungen erforderlich, durch die die Montage sehr kompliziert ist. Um reproduzierbare Verhältnisse zu erhalten, müssen die Verbindungsleitungen der Bauteile bzw. Baugruppen untereinander immer an exakt der gleichen Stelle verlegt sein, damit sie immer die gleiche Lage einnehmen können. Dies ist praktisch nur schwierig zu erreichen. Darüberhinaus liegen die einzelnen Baugruppen auch nicht ausreichend gut voneinander entfernt, bzw. sind nicht ausreichend weit voneinander getrennt, so daß mit Verschleppung von Spannungen bei Kabelbruch zu rechnen ist, und dadurch verursacht wird die Trennung der Hochspannungsbereiche von den Niederspannungsbereichen durch die auffedernden Kabelenden überbrückt, so daß durchaus auch Überschläge mit entsprechenden Beschädigungen auftreten können. Zusätzlich ist zu beachten, daß aufgrund der Bauweise der Zusammenbau (Montage) und der Austausch einzelner Bauelemente wegen des hohen Verdrahtungsaufwandes sehr schwierig sind.

Ein Netzgerät, bei dem zumindest das « Kabelwirrwarr » beseitigt ist, ist aus der DE-OS 26 52 813 bekanntgeworden. Dort werden die einzelnen Baugruppe in bestimmter räumlicher Zuordnung zueinander gesetzt, so daß die Stromflußrichtung im großen und ganzen insgesamt hintereinander mäanderförmig ausgebildet ist. Insbesondere aus der Figur 4 der DE-OS 26 52 813 ist auch ersichtlich, daß die einzelnen Baugruppen durch Tragwände gehaltert sind, die auch eine Trennung einzelner Baugruppen voneinander bewirken.

Ein Gehäuse für einen Kanalumsetzer für Trägerfrequenzsysteme, also nicht für Stromversorgsgeräte, ist aus der DE-AS 2 110 462 bekannt geworden. Dort sind die einzelnen Baugruppen, nämlich der Empfangskanal, der Sendekanal und die Signaleinrichtung, übersichtlich und mit glatt durchgehendem Nachrichtenfluß angeordnet, was auch bei dem Gerät gemäß der CH-PS 256 367 der Fall ist.

Bei allen diesen letztgenannten Geräten kommt es auf eine extrem dichte Packung der einzelnen Baugruppen nicht an. Wenn aber ein derartiges Versorgungsgerät bspw. auf Schiffen oder in Luftfahrzeugen verwendet werden soll, dann muß das Gerät bei optimaler Leistung und günstiger Montageart in den äußeren Abmessungen möglichst klein sein.

Aufgabe der Erfindung ist es daher, ein Versorgungsgerät der eingangs genannten Art zu schaffen, bei dem die äußeren Abmessungen unter Berücksichtigung der Tatsache, daß innerhalb des Gerätes Niederspannungs- und Hochspannungsbaugruppen vorhanden sind, möglichst klein sind.

Diese Aufgabe wird erfindungsgemäß gelöst durch die kennzeichnenden Merkmale des Anspruches 1.

Eine erste Maßnahme zur Verringerung der äußeren Abmessungen besteht erfindungsgemäß also darin, daß auf der Bodenplatte des Gehäuses die praktisch die gesamte Bodenplatte überdeckende Leiterplatte vorgesehen ist, auf der die einzelnen Verbindungsleitungen zu den einzelnen Baugruppen in Form von Leiterbahnen (Busse) aufgebracht .sind. Dadurch wird einerseits das « Kabelwirrwarr », also die unübersichtliche Kabellage beseitigt und andererseits auch eine exakt reproduzierbare Leitungsführung erreicht, da diese Leitungsführung nämlich maschinell herstellbar ist. Dies führt außer zu einem übersichtlicheren Aufbau des Gerätes auch zu einer verminderten, genau vorher definierbaren Störbeeinflussung, so daß hierbei vorher geeignete reproduzierbare Maßnahmen getroffen werden können. Außerdem werden Kabelbrüche und dadurch bewirkte Überschläge im Inneren des Gerätes nicht mehr vorkommen.

Eine zusätzliche Maßnahme zur Verbesserung oder zur Erhöhung der Packungsdichte ist erfindungsgemäß das Vorsehen der Trennwand oder -platte, die das gesamte Gehäuse in zwei Bereiche unterteilt, von denen der eine Bereich die Schalt- und Regelstufen und der andere gemäß Kennzeichen des Anspruches 2 bzw. 3 die großvolumigen Bauteile aufnimmt.

Diese Trennwand hat darüberhinaus gemäß den Ansprüchen 4 bis 7 auch die Funktion der Halterung des Leistungstransformators, wobei sie der Abfuhr der Wärme aus dem Leistungstransformator dient, in dem gemäß kennzeichnenden Merkmalen des Anspruches 4 die Lappen an der Trennwand angeformt sind, die gemäß Anspruch 5 unmittelbar in den Bereich der Wicklung des Transformators eingebracht werden. Nach der Montage des Leistungstransformators an der Trennwand wird dieser gemäß Anspruch 7 an der Trennwand durch Umgießen mit Gießharz festgelegt bzw. befestigt. Dabei befindet sich der Bereich der Primärwicklung auf der einen Seite der Trennwand und der Bereich bzw. der Abgriff der Sekundärwicklung auf der anderen Seite, wie im Anspruch 8 angegeben.

Die Trennwand unterteilt den Gehäuseinnenraum in einen relativ schmalen Raum und einen demgegenüber großen Raum. Der schmale Raum enthält die Schaltstufe und die Regelstufe, die beide einerseits an einer Steckerleiste auf der Leiterplatte und andererseits, insbesondere was die Schaltstufe betrifft, an der Trennwand befestigt bzw. fixiert ist. Die Schaltstufe ist unmittelbar im Bereich der Primärstufe des Leistungstransformators im schmalen Raum untergebracht, so daß die Anschlüsse der Primärseite des Leistungstransformators die Ausgänge der auf einer Leiterplatte aufgebrachten Schaltstufe direkt kontaktieren (siehe Anspruch 8). Dadurch werden ebenfalls längere Kabelleitungsverbindungen vermieden.

Das Versorgungsgerät besitzt — wie alle Geräte seiner Art — einen Gleichrichter. Dieser ist erfindungsgemäß nach Anspruch 9 mit seinem Kühlkörper an der Trennwand befestigt, wobei der Kühlkörper mindestens zwei zu Gruppen vereinigte Kühlrippen aufweist, die einen U-förmigen Längskanal bilden, in den gemäß Kennzeichen des Anspruches 10 die in an sich bekannter Weise als langgestrecktes Bauteil ausgebildete Drossel einsetzbar ist, was einerseits die Packungsdichte erhöht und andererseits auch den magnetischen Streufluß der Drossel verringert.

Weitere vorteilhafte Ausgestaltungen der Erfindung sind den weiteren Unteransprüchen zu entnehmen.

Anhand der Zeichnung, in der ein Ausführungsbeispiel der Erfindung dargestellt ist, soll die Erfindung näher erläutert und beschrieben werden.

Es zeigt :

Fig. 1 eine Aufsicht auf ein Stromversorgungsgerät,

Fig. 2 eine Schnittansicht gemäß Linie II-II der Figur 1,

Fig. 3 eine Schnittansicht gemäß der Schnittlinie III-III der Figur 1,

Fig. 4 eine Schnittansicht gemäß der Schnittlinie IV-IV der Figur 5,

Fig. 5 eine Aufsicht auf die Trennwand mit eingesetztem Leistungstransformator und

Fig. 6 eine Aufsicht gemäß Pfeilrichtung VI-VI der Figur 5.

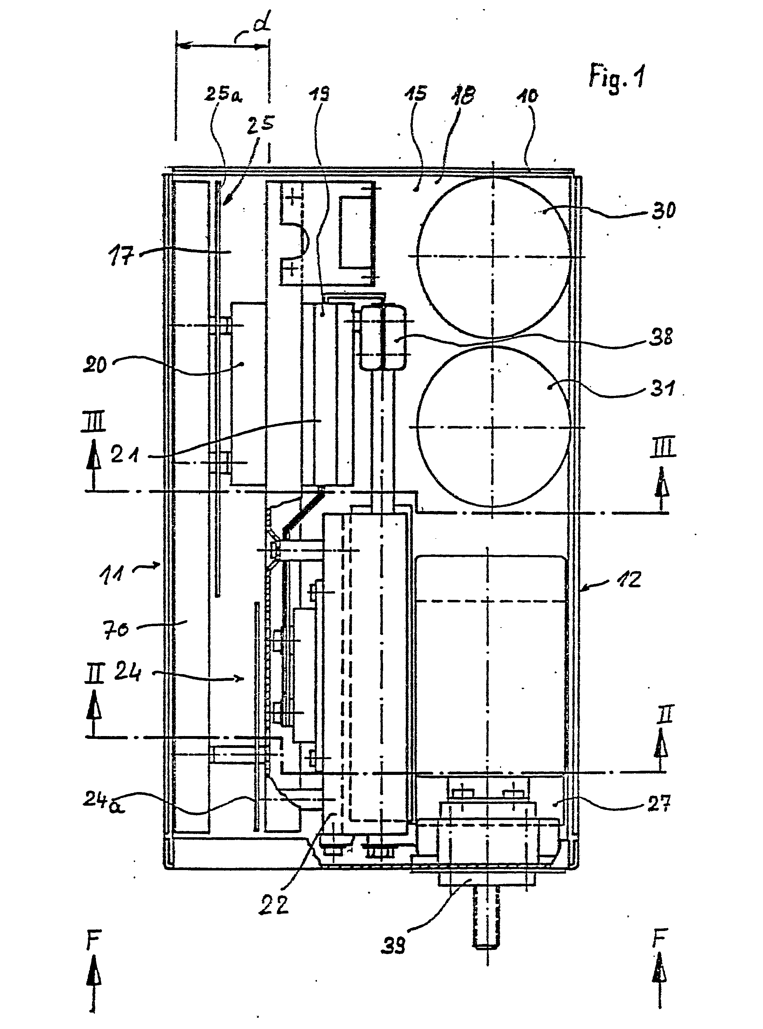

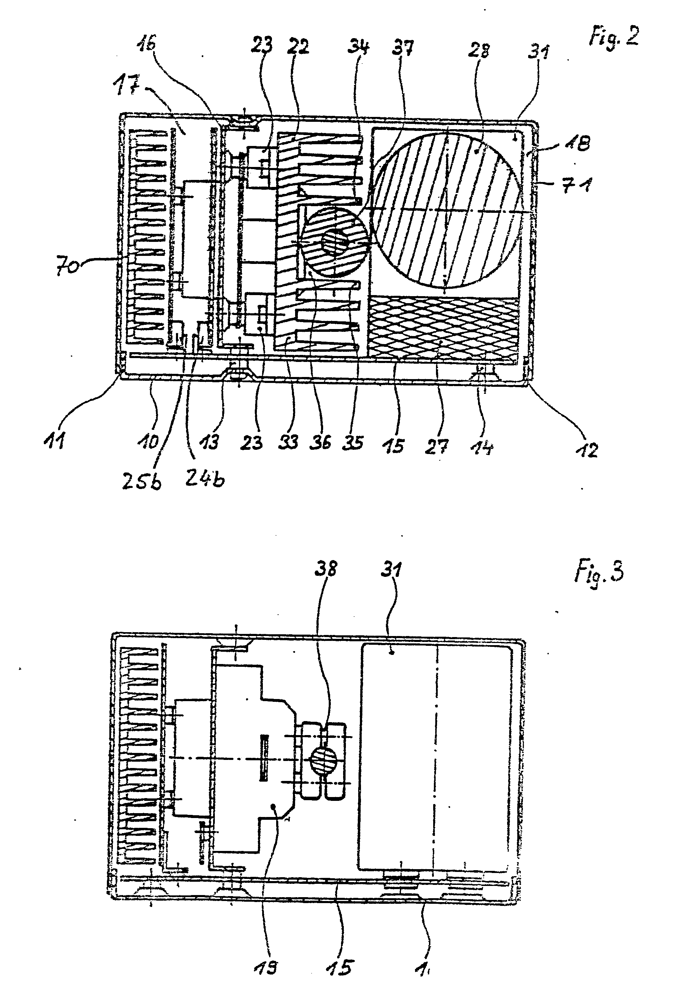

Die Figur 1 zeigt eine Einsicht in ein erfindungsgemäßes Versorgungsgerät, kurz auch einfach Gerät genannt. Eine Grundplatte 10, deren Längskanten 11 und 12 abgewinkelt sind, so daß der Grundrahmen 10 bzw. die Bodenplatte 10 eine U-Form bildet (siehe Figur 2), trägt über Pfosten 13 und 14 eine Leiterplatte 15, auf der die Verbindungsleitungen als Leiterbahnen aufgebracht sind, die Verbindungsleitungen sind nicht gezeigt, da Leiterplatten mit Leiterbahnen als solche an sich bekannt sind. In einem relativ geringen Abstand d von der linken Längskante 11 ist an der Grundplatte 10 eine Trennwand 16 befestigt, die das Gerät in zwei Räume 17 und 18 unterteilt, von denen der Raum 17 im Vergleich zu dem Raum 18 langgestreckt und sehr schmal ist.

Die Trennwand 16, die weiter unten näher beschrieben werden soll, trägt einen Leistungstransformator 19, dessen Primärbereich 20 sich im Raum 17 und dessen Sekundärbereich 21 sich im Raum 18 befindet. Der Leistungstransformator 19 sitzt in der hinteren Hälfte des Gerätes, von der Frontseite F aus gesehen. Nach vorne zu trägt die Trennwand 16 einen Kühlkörper 22 zur Kühlung von zwischen der Trennwand 16 und dem Kühlkörper 22 angebrachten Dioden 23, die als Gleichrichter zusammengeschaltet sind. In dem Raum 17 befindet sich in dem vorderen Bereich eine auf einer Leiterplatte 24a angebrachte Regelstufe 24 und auf einer im Bereich des Leistungstransformators 19 angeordneten Leiterplatte 25a ist eine Schaltstufe aufgebracht, die geregelt von der Regelstufe 24 den pulsbreitenmodulierten hochfrequenten Pulsstrom erzeugt. Die einzelnen Bauelemente auf den Leiterplatten 24a und 25a, die jeweils die Regel- und Schaltstufe bilden, sind der Übersichtlichkeit wegen nicht gezeichnet.

In dem Raum 18 befindet sich in dem Bereich der vorderen Seite auf der Leiterplatte 15 aufgebracht eine Filter- und Gleichrichteranordnung 27, in der der zugeführte Wechselstrom gleichgerichtet und gefiltert wird.

Oberhalb der Einheit 27, wie die Filter- und Gleichrichteranordnung im folgenden genannt werden soll, befindet sich ein erster Kondensator 28, und in dem noch verbleibendem Raum zwischen dem Leistungstransformator 19 und der rechten Längskante 12 und dem Bereich zwischen dem Kondensator 28 und der hinteren Querkante 29 sind zwei weitere Kondensatoren 30 und 31 auf der Leiterplatte 15 befestigt.

Wie die elektrische Zusammenschaltung der einzelnen Bauelemente bzw. Baugruppen erfolgt, ist für die Erfindung von nebensächlicher Bedeutung, so daß hierauf nicht näher eingegangen werden soll. Von Bedeutung ist lediglich, daß sich in dem Raum 17 die Schalt- und Regelstufe 24, 25 also die « kleinvolumigen » Baugruppe und in dem Raum 18 die großvolumigen Baugruppen befinden. Die Verbindungsleitungen sind die Leiterbahnen auf der Leiterplatte 15, und die elektrische Kontaktierung der Schalt- und Regelstufe in den Leiterbahnen erfolgt durch Steckerleisten 24b, 25b, die zusätzlich die mechanische Halterung der Leiterplatten 24a, 25a auf der Leiterplatte 15 bewirken.

Aus Figur 2 ist ersichtlich, daß der Kühlkörper 22 eine ebene Platte 33 aufweist, auf deren einen Seite zwei Gruppen 34 und 35 von Kühlrippen angeformt sind, zwischen denen ein Kanal 36 gebildet ist, in dem eine an sich bekannte langgestreckte zylinderförmige Drossel 37 verläuft, deren eines Ende mit dem Leistungstransformator mittels einer Klemmenverbindung 38 und deren anderes Ende mit einem Außenanschluß 39 verbunden sind. Weil die Kühlrippen 34 und 35 auf zwei Seiten die Drossel 37 überdecken bzw. bei bestimmten konstruktiven Ausgestaltungen der Drossel überragen, wird in besonders vorteilhafter Weise eine erhebliche Verringerung des magnetischen Streufeldes der Drossel bewirkt.

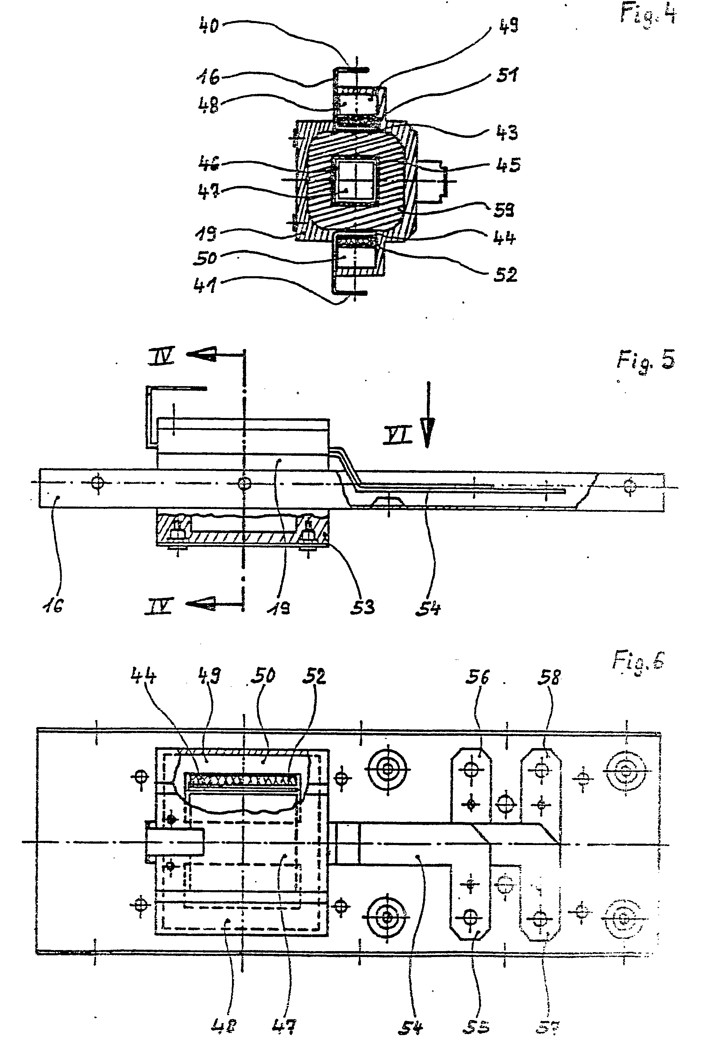

In der Figur 3 ist die Bodenplatte 10, die auf der Bodenplatte festgehaltene bzw. befestigte Leiterplatte 15 sowie der Leistungstransformator 19 und der Kondensator 31 zu sehen. Im Raum 17 ist ein weiterer Kühlkörper 70 untergebracht, der direkt neben der linken Längskante 11 und parallel dazu sich durch den gesamten Raum 17 erstreckt und zur Kühlung der Schalt- und Regelstufe und insgesamt zur Wärmeabfuhr dient.

Die Figur 4 zeigt in Schnittansicht, wie der Leistungstransformator 19 an der Trennwand 16 befestigt ist. Die Trennwand 16 ist ein langgestrecktes ebenes flächiges Bauelement, an dessen Längskanten Abbiegungen 40 bzw. 41 vorgesehen sind, so daß die Trennwand insgesamt eine U-Form bildet, deren Öffnung in den Raum 18 hin offen ist. Im hinteren Bereich besitzt die Trennwand 16 eine Öffnung 42, die durch Ausstanzen und Abkanten von Lappen 43 und 44 gebildet ist. Der zu montierende Transformator 19 besitzt einen Spulenkörper 45, der in der Figur 4 lediglich schematisch dargestellt ist, der in seinem mittleren Bereich eine Öffnung 46 aufweist, durch die der mittlere Schenkel 47 eines in geeigneter Form zusammengesetzten Kernes 49 hindurchgreift. Die beiden Außenschenkel 48 und 50 des Kernes befinden sich außerhalb der Spulenwicklung, wobei zusätzlich noch Puffer 51 und 52 aus elastischem Material jeweils an der Innenfläche der Außenschenkel 48 und 50 eingelegt sind. Die so gebildete Einheit wird über die beiden Laschen 43 und 44 gesteckt und zwar so, daß sich die beiden Laschen 43 und 44 jeweils zwischen der Spule 45 und den eingelegten Puffern 51 und 52 befinden. Nach dieser Montage wird die Trennwand 16 in eine Spritz- oder Gießform gebracht ; der Leistungstransformator wird mit einer Gießharzumhüllung 53 umgeben, wodurch er quasi integraler Bestandteil der Trennwand wird. Dabei dienen die beiden Lappen 43 und 44, die unmittelbar mit dem Spulenkörper und der Wicklung in Berührung stehen, als Wärmeabführungselemente für die im Inneren der Wicklung entstehenden Wärme unmittelbar aus dem Transformator heraus nach draußen. Natürlich ist die Wicklung von den Lappen isoliert, damit keine Kurzschlüsse auftreten.

Die Figur 5 zeigt die Anordnung von oben mit dem Transformator 19 und der Trennwand 16. Man erkennt, daß aus dem Transformator bzw. aus der Gießharzumhüllung 53 Anschlußleiter 54 in Form von Bändern ·herausgeführt sind, die dann mit den an dem Kühlkörper 22 angebrachten Dioden 23 fest verbunden sind. Die Anschlußleiter 54 verzweigen sich in Abzweigfahnen 55, 56, 57 und 58, wobei diese im wesentlichen senkrecht zu der Längserstreckung der Anschlußleiter 54 verlaufen.

Die Figur 6 zeigt teilweise den Transformator geschnitten, wobei die Lasche 44 und der Puffer 52 sichtbar ist. Der Kern 49 besitzt in der Mitte den Mittelsteg 47 und den Außenstegen 48 und 50.

Das Versorgungsgerät wird oben abgedeckt durch ein am Gehäuseboden befestigtes Gehäuseoberteil 71 (siehe Figur 2).

**Patentansprüche**

1. Stromversorgungsgerät mit in einem Gehäuse befindlichen elektronischen Baugruppen, darunter eine Schalt- und eine Regelstufe sowie z. B. Gleichrichter-, Filtergruppen, die mittels Verbindungsleitungen verbunden sind, und mit einem Leistungstransformator, dadurch gekennzeichnet, daß in Abstand zu dem Gehäuseboden (10) eine Leiterplatte (15) vorgesehen ist, auf der die Verbindungsleitungen der einzelnen Baugruppen untereinander in Form von Leiterbahnen aufgebracht sind, daß an dem Gehäuseboden (10) eine in dessen Längsrichtung senkrecht zum Gehäuseboden verlaufende Trennwand (16) vorgesehen ist, die den Gehäuseraum in einen ersten und einen zweiten Raum (17, 18) unterteilt, von denen der erste Raum (17) lediglich die Schalt- und die Regelstufe (25, 24) aufnimmt, und daß der Leistungstransformator (19) eine Öffnung (42) in der Trennwand (16) durchgreift und daran befestigt ist, wobei dessen Primärseite sich in dem ersten Raum (17) nahe der Schaltstufe (25) befindet.

2. Stromversorgungsgerät nach Anspruch 1, dadurch gekennzeichnet, daß die Trennwand (16) nahe einer Längskante des Gehäusebodens (10) an diesem befestigt ist, so daß der erste Raum (17) langgestreckt, schmal und kleinvolumig und der zweite Raum (18) großvolumig ist.

3. Stromversorgungsgerät nach Anspruch 2, dadurch gekennzeichnet, daß in dem kleinvolumigen ersten Raum (17) die Schalt- und Regelstufe (25, 24) und in dem großvolumigen zweiten Raum (18) Bauelemente mit großen Abmessungen, z. B. Ausgangsgleichrichter, Drossel, Kondensatoren, Widerstände, untergebracht sind.

4. Stromversorgungsgerät nach einem der Ansprüche 1 bis 3, dadurch gekennzeichnet, daß an zwei sich gegenüberliegenden Kanten der Öffnung (42) zwei Lappen (43, 44) angeformt sind, an denen der Leistungstransformator festgelegt ist.

5. Stromversorgungsgerät nach Anspruch 4, dadurch gekennzeichnet, daß die Lappen in den Zwischenraum zwischen der Wicklung und außerhalb der Wicklung befindlicher Stege (48, 50) des Kernes (49) des Leistungstransformators (19) eingreifen und dabei die Wicklung im wesentlichen berühren und so zur Abfuhr der in der Wicklung des Leistungstransformators entstehenden Wärme dienen.

6. Stromversorgungsgerät nach Anspruch 5, dadurch gekennzeichnet, daß zwischen den Lappen (43, 44) und der Innenfläche der beiden Stege (48, 50) des Magnetkernes (49) jeweils eine Lage (51, 52) aus elastisch weichem Material vorgesehen ist, das zum Ausgleich von Wärmedehnungen dient.

7. Stromversorgungsgerät nach einem der vorigen Ansprüche, dadurch gekennzeichnet, daß der Leistungstransformator die Trennwand (16) beiderseitig überragt und an der Trennwand (16) durch Gießharz festgelegt ist.

8. Stromversorgungsgerät nach Anspruch 7, dadurch gekennzeichnet, daß die Primärseite des Leistungstransformators (19) direkt an einer die Schaltstufe (25) tragenden Leiterplatte (25a) benachbart und mit dieser kontaktiert ist.

9. Stromversorgungsgerät nach einem der vorigen Ansprüche, mit einem aus Dioden gebildeten Gleichrichter und einem damit verbundenen Kühlkörper, dadurch gekennzeichnet, daß der Kühlkörper (22) an der Trennwand befestigt ist, und daß die Kühlrippen (34, 35) zwei in Abstand zueinander angeordnete Kühlrippengruppen bilden, zwischen denen ein U-förmiger Kanal (36) vorgesehen ist, der zur Aufnahme bzw. Führung weiterer elektronischer Bauelemente (37) dient.

10. Stromversorgungsgerät nach Anspruch 9, mit einer Drossel, dadurch gekennzeichnet, daß die Drossel in an sich bekannter Weise langgestreckt ausgebildet und in den Kanal eingelegt ist, wobei der auf Pluspol befindliche Kühlkörper (22) mit seinen Kühlrippen die auf Minuspol befindliche Drossel überragt, und dabei gleichzeitig die Kühlrippen zur Verringerung des magnetischen Streuflusses der Drossel dienen.

11. Stromversorgungsgerät nach einem der vorigen Ansprüche, dadurch gekennzeichnet, daß der erste kleinvolumige Raum (17) zusätzlich einen weiteren Kühlkörper (70) für die Schalt- und Regelstufe (25, 24) aufnimmt, der in dem ersten Raum in Richtung seiner Längserstreckung verläuft, wobei die Schalt- und die Regelstufe (25, 24) zwischen dem weiteren Kühlkörper (70) und der Trennwand (16) angeordnet sind.

12. Stromversorgungsgerät nach einem der vorigen Ansprüche, dadurch gekennzeichnet, daß Leiterplatten (25a, 24a) der Schalt- und Regelstufe (25, 24) an der Leiterplatte (15) mit den Verbindungsleitungen mittels gleichzeitig der Kontaktierung dienenden Steckanschlüssen gehaltert sind.

## Claims

1. Power supply unit comprising electronic assemblies, including a switching stage and a regulating stage and, for example, rectifier, filter groups, which are located in a housing and which are connected by means of connecting lines, and comprising a power transformer, characterized in that a circuit board (15) is provided at a distance from the housing bottom (10), on which circuit board the connecting lines between the individual assemblies are mounted in the form of conductor tracks, that on the housing bottom (10) a partition wall (16), which runs perpendicularly with respect to the housing bottom in its longitudinal direction, is provided which subdivides the housing space into a first and a second space (17, 18), the first space (17) of which only accommodates the switching and the regulating stage (25, 24), and that the power transformer (19) penetrates through an opening (42) in the partition wall (16) and is attached thereto, its primary side being located in the first space (17) close to the switching stage (25).

2. Power supply unit according to Claim 1, characterized in that the partition wall (16) is attached to the housing bottom close to one longitudinal edge of the housing bottom (10) so that the first space (17) is longitudinally extended, narrow and of small volume and the second space (18) is of large volume.

3. Power supply unit according to Claim 2, characterized in that the switching and regulating stage (25, 24) is accommodated in the small-volume first space (17) and components having large dimensions, for example output rectifer, choke, capacitors, resistors are accommodated in the large-volume second space (18).

4. Power supply unit according to one of Claims 1 to 3, characterized in that two lugs (43, 44), at which the power transformer is fixed in location, are integrally formed at two edges of the opening (42) which are opposite to one another.

5. Power supply unit according to Claim 4, characterized in that the lugs engage the intermediate space between the winding and legs (48, 50), located outside the winding, of the core (49) of the power transformer (19) and in this arrangement are essentially in contact with the winding and are thus used for removing the heat generated in the winding of the power transformer.

6. Power supply unit according to Claim 5, characterized in that a layer (51, 52) of elastically soft material, which is used for compensating thermal expansions, is provided in each case between the lugs (43, 44) and the inside face of the two legs (48, 50) of the magnetic core (49).

7. Power supply unit according to one of the preceding claims, characterized in that the power transformer projects past the partition wall (16) on both sides and is fixed to the partition wall (16) by means of casting resin.

8. Power supply unit according to Claim 7, characterized in that the primary side of the power transformer (19) is directly adjacent to a circuit board (25a) which carries the switching stage (25) and is in contact with the latter.

9. Power supply unit according to one of the preceding claims, comprising a rectifier formed of diodes and a heat sink connected thereto, characterized in that the heat sink (22) is attached to the partition wall and that the cooling ribs (34, 35) form two cooling rib groups which are arranged at a distance from one another and between which a U-shaped channel (36) is provided which is used for accommodating or arranging further electronic components (37).

10. Power supply unit according to Claim 9, comprising a choke, characterized in that the choke is constructed in a longitudinally extended manner known per se and is inserted into the channel, in which arrangement the heat sink (22), which is at positive potential, projects past the choke, which is at negative potential, with its cooling ribs and in this arrangement the cooling ribs, at the same time, are used for reducing the stray magnetic flux of the choke.

11. Power supply unit according to one of the preceding claims, characterized in that the first small-volume space (i7) additionally accommodates a further heat sink (70) for the switching and regulating stage (25, 24), which heat sink runs in the direction of its longitudinal extent in the first space, in which arrangement the switching and the regulating stage (25, 24) are arranged between the further heat sink (70) and the partition wall (16).

12. Power supply unit according to one of the preceding claims, characterized in that circuit boards (25a, 24a) of the switching and regulating stage (25, 24) are held by means of plug-in connections, used at the same time for making contact, at the circuit board (15) having the connecting lines.

**Revendications**

1. Bloc d'alimentation en courant, avec des ensembles électroniques se trouvant dans un coffret, dont un étage commutateur et un étage régulateur ainsi que p. ex. des ensembles redresseurs et des ensembles de filtrage, qui sont reliés par des conducteurs de liaison, et avec un transformateur de puissance, caractérisé par le fait qu'à distance du fond de coffret (10) est prévue une plaque conductrice (15) sur laquelle les conducteurs de liaison des différents ensembles entre eux sont disposés sous la forme de bandes conductrices, que sur le fond de coffret (10) est prévue une cloison (16) s'étendant dans le sens de la longueur du coffret et perpendiculairement au fond de coffret, cloison qui subdivise l'espace du coffret en une première chambre et une deuxième chambre (17, 18), la première de ces chambres (17) recevant uniquement l'étage de commutation (25) et l'étage de régulation (24), et que le transformateur de puissance (19) traverse un orifice (42) de la cloison (16) et y est fixé, le côté primaire du transformateur se trouvant dans la première chambre (17), près de l'étage de commutation (25).

2. Bloc d'alimentation en courant selon la revendication 1, caractérisé par le fait que la cloison (16), à proximité d'une arête longitudinale du fond de coffret (10), est fixée à celui-ci de telle façon que la première chambre (17) soit allongée, étroite et de faible volume et que la seconde chambre (18) soit de grand volume.

3. Bloc d'alimentation en courant selon la revendication 2, caractérisé par le fait que dans la première chambre (17) de faible volume sont logés l'étage de commutation (25) et l'étage de régulation (24) et que la seconde chambre (18) de grand volume renferme des composants de fortes dimensions, tels que redresseur de sortie, bobine, condensateurs et résistances.

4. Bloc d'alimentation en courant selon l'une quelconque des revendications 1 à 3, caractérisé par le fait que sur deux arêtes opposées de l'orifice (42) sont formées deux languettes (43, 44) auxquelles est fixé le transformateur de puissance.

5. Bloc d'alimentation en courant selon la revendication 4, caractérisé par le fait que les languettes pénètrent dans l'espace intermédiaire entre l'enroulement et les jambes (48, 50) du noyau (49) du transformateur de puissance (19) situées à l'extérieur de l'enroulement, et se trouvent ainsi en contact essentiellement avec l'enroulement et servent ainsi à l'évacuation de la chaleur que dégage l'enroulement du transformateur de puissance.

6. Bloc d'alimentation en courant selon la revendication 5, caractérisé par le fait qu'entre les languettes (43, 44) et la surface interne des deux jambes (48, 50) du noyau magnétique (49) est à chaque fois prévue une couche (51, 52) d'une matière molle et élastique, servant à la compensation des dilatations thermiques.

7. Bloc d'alimentation en courant selon l'une quelconque des revendications précédentes, caractérisé par le fait que le transformateur de puissance dépasse la cloison (16) des deux côtés et est fixé à la cloison (16) au moyen de résine de coulée.

8. Bloc d'alimentation en courant selon la revendication 7, caractérisé par le fait que le côté primaire du transformateur de puissance (19) est directement adjacent à une plaque conductrice (25a) qui supporte l'étage commutateur (25) et est mis en contact avec celle-ci.

9. Bloc d'alimentation en courant selon l'une quelconque des revendications précédentes, avec un redresseur constitué de diodes et un dissipateur relié à celui-ci, caractérisé par le fait que le dissipateur thermique (22) est fixé à la cloison et que les ailettes de refroidissement (34 35) forment deux groupes d'ailettes de refroidissement disposés à distance l'un de l'autre entre lesquels est prévu un canal en forme de U (36) servant à la réception ou au guidage d'autres composants électroniques (37).

10. Bloc d'alimentation en courant selon la revendication 9, avec une bobine, caractérisé par le fait que la bobine, d'une façon connue en soi, est formée en longueur et posée dans le canal, le dissipateur thermique (22) se trouvant sur le pôle + dépassant avec ses ailettes de refroidissement la bobine qui se trouve sur le pôle —, les ailettes de refroidissement servant en même temps à la diminution du flux de dispersion magnétique de la bobine.

11. Bloc d'alimentation en courant selon l'une quelconque des revendications précédentes, caractérisé par le fait que la première chambre (17) de faible volume reçoit en outre un autre dissipateur thermique (70) pour l'étage commutateur et l'étage régulateur (25, 24), dissipateur qui s'étend dans la première chambre dans le sens de la longueur, l'étage commutateur et l'étage régulateur (25, 24) étant disposés entre cet autre dissipateur thermique (70) et la cloison (16).

12. Bloc d'alimentation en courant selon l'une quelconque des revendications précédentes, caractérisé par le fait que des plaques conductrices (25a, 24a) de l'étage commutateur et de l'étage régulateur (25, 24) sont fixées à la plaque conductrice (15) portant les conducteurs de liaison à l'aide de connecteurs à enfichage servant en même temps à l'établissement des contacts.

Fig. 1

Fig. 2

Fig. 3

Fig. 4

Fig. 5

Fig. 6